# EUROPÄISCHE PATENTANMELDUNG

(11) **EP 1 798 775 A2**
(43) Veröffentlichungstag der Anmeldung: **20.06.2007**
(21) Anmeldenummer: 06026015.5
(22) Anmeldetag: 15.12.2006
(51) Int. Cl.: H01L 31/042

(54) **Kristallines photovoltaisches Solarmodul**

(30) Priorität: 17.12.2005 DE 202005019945 U
(71) Anmelder: SOLARWATT AG, 01109 Dresden (DE)
(72) Erfinder: Münch, Markus, Dipl.-Ing., 01640 Coswig (DE)
(74) Vertreter: Drechsler, Gottfried

(57) **Zusammenfassung**

Die Erfindung betrifft ein kristallines photovoltaisches Solarmodul in Plattenform.

Aufgabe ist es, ein Solarmodul zu schaffen, das vor allem bei größeren Solarzellengeometrien die mechanische Beanspruchung der Verbindungsleiter der benachbarten Solarzellen verringert und damit die Ausfallrate der Verbindungen einzelner Solarzellen reduziert.

Erfindungsgemäß werden das Deckseitenmaterial 2 oder das Rückseitenmaterial 3 oder beide d. h. das Deckseitenmaterial 2 und auch das Rückseitenmaterial 3 des kristallinen photovoltaischen Solarmoduls 1 aus einem speziellen Bor-Silikat-Glas 7 mit einem Ausdehnungskoeffizienten von kleiner gleich 4,5x10⁻⁶ /K bis größer gleich 2x10⁻⁶/K bei Raumtemperatur ausgebildet. Die Solarzellen 5 sind, in ein Einbettungsmaterial 4 eingelegt. Die eingebetteten Solarzellen 5 größerer Abmessungen sind mit ebenfalls im Einbettungsmaterial 4 eingebetteten Solarzellenverbindem 6 untereinander verschalteten. Seitlich außen ist um das Deckseitenmaterial 2, die eingebetteten Solarzellen 5 und um angeordneten Rückseitenmaterial 3 ein Modulrahmen mit nach außen geführten Anschlüssen angeordnet. Das Bor-Silikat-Glas 7 kann wahlweise nur als Deckseitenmaterial 2 oder nur als Rückseitenmaterial 3 in Kombination mit einem geeigneten anderen Material oder auch beidseitig als Deck- und Rückseitenmaterial 2, 3 angeordnet sein. Dies hat den Vorteil, dass die Ausdehnung der Seitenmaterialien mit der Ausdehnung der Solarzellen vor allem bei Solarzellen größerer Abmessungen mit einer Kantenlänge von größer - gleich 150 mm nahezu identisch verläuft.

## Beschreibung

Die Erfindung betrifft ein kristallines photovoltaisches Solarmodul insbesondere in Plattenform.

Photovoltaische Solarmodule bestehen aus einer Vielzahl untereinander verschalteter Solarzellen, die in ein Einbettungsmaterial eingelegt sind und von einem Deckseitenmaterial und Rückseitenmaterial umschlossen sind um die Solarzellen vor schädlichen Einflüssen zu schützen. Photovoltaische Solarmodule sind auf Grund ihres exponierten Einsatzes erheblichen Temperaturschwankungen unterworfen. Diese Temperaturschwankungen können auch innerhalb kurzer Zeiträume durch Wetteränderungen bzw. Beschattungssituationen auftreten. Photovoltaische Solarmodule können trotzt Hinterlüftung durchaus Übertemperaturen von weit über 40 K (Untersuchungen eines Fraunhofer Institutes) erreichen. Dadurch bedingt werden eine Reihe von konstruktiven Maßnahmen vorgesehen, die vor allem die Schwachstelle der Verbindungsleitungen der einzelnen Solarzellen untereinander innerhalb des photovoltaischen Solarmoduls betreffen. Ein Problem sind dabei die unterschiedlichen Ausdehnungskoeffizienten der einzelnen Materialien wie Silizium für die Solarzellen und Kalk-Natron-Gläser für die Deckseite und/oder Rückseite.

Es ist bekannt, dass sich handelsübliche Kalk-Natron-Gläser bei Erwärmung in Abhängigkeit definiert linear mit ca. 9x10⁻⁶ /K ausdehnen. Silizium hat dagegen ein nichtlineares Ausdehnungsverhalten ausgehend bei Raumtemperatur von 2,6x10⁻⁶/K.

Bei bestimmten Witterungsbedingen können in photovoltaischen Solarmodulen Temperaturen bis 90° C erreicht werden. Die Ausdehnungsunterschiede zwischen Silizium und dem eingesetzten Kalk-Natron-Glas führen zur Dehnung und Stauchung sowie zur Verformung und Versprödung der Verbindungsleiter im Zellenabstand. Die Folge dieser dauerhaften zyklischen Belastungen führen in der Regel vorzeitig zum Verbindungsbruch. Im Vergleich zu einer Solarzelle mit 100 Millimeter Kantenlänge, wird bei Solarzellen mit 156 mm Kantenlänge der Verbindungsleiter im Bereich zwischen den angeordneten und untereinander verbundenen Solarzellen ca. 60 % stärker gedehnt. Bei Kantenlängen der Solarzellen von 200 mm steigt dieser Vergleichswert auf über 100 %.

Aus den beiden Schriften DE 41 40 682 A1und DE 41 40 683 A1 ist es bekannt für Solarmodule in Plattenform die Außenscheibe d. h. das Deckseitenmaterial und/oder eine weitere Innenscheibe aus einem Weißglas, wie Silikatglas herzustellen.

Ein ähnlicher Aufbau eines Solarmoduls ist in der DE 41 28 766 A1 gezeigt. Auch hier wird sowohl als Trägermaterial, d. h. Rückseitenmaterial, als auch als transparente Deckscheibe, d. h. Deckseitenmaterial, Natronsilikatglas, und zwar insbesondere Weißglas eingesetzt. Dabei wird dieses Weisglas in der Art eines Sicherheitsglases eingesetzt.

In den beiden technischen Lösungen DE 31 50 539 A1 und DE 26 20 832 A1 wird auf die Verwendung von Bor als Dotierungsmaterial für die eigentlichen Solarzellen aus Silizium eingegangen.

In der DE 101 08 992 C2 wird auf die Verwendung eines solarisationsstabilen Borsilikatglases eingegangen. Dabei wurde ein Borsilikatglas vorgeschlagen, dass auf Grund seiner Eigenschaften besonders für die Herstellung von Lampenkolben für Blitzlampen und Gasentladungslampen geeignet ist. In einer weiteren Spezifizierung bei speziellen vergleichsweise hohen Titanoxid-Gehalten (TiO₂) ist dieses Glasmaterial geeignet für die Herstellung von sogenannten "Backlights", beispielsweise für die Hintergrundbeleuchtung von Displays von Personalcomputern, Laptops, Notebooks, Taschenrechnern, Fahrzeugnavigationssystemen, Scannern, Spiegeln, Bildern und Bremslichtern bei Fahrzeugen. Die Materialzusammensetzung ist dabei so zusammengestellt, dass ein thermischer Ausdehnungskoeffizient zwischen 3,7x10⁻⁶/K bis 4,2x10⁻⁶/K erreicht werden soll, damit der vorstehende Einsatz realisiert werden kann.

Aufgabe der Erfindung ist es, ein kristallines photovoltaisches Solarmodul zu schaffen, das vor allem bei größeren Solarzellengeometrien die mechanische Beanspruchung der Verbindungsleiter der benachbarten Solarzellen verringert und damit die Ausfallrate der Verbindungen einzelner Solarzellen reduziert und letztendlich eine längere Lebensdauer des gesamten Solarmoduls ermöglicht.

Die Aufgabe wird erfindungsgemäß durch die Merkmale des 1. Schutzanspruchs gelöst. Weitere zweckmäßige Ausgestaltungen der Erfindung sind Gegenstand der Unteransprüche. In neuartiger Art und Weise werden erstmals für kristalline photovoltaische Solarmodule, insbesondere für kristalline photovoltaische Solarmodule 1 in Plattenform, für die bislang als Deckseitenmaterial und Rückseitenmaterial übliche Silikatgläser oder als Rückseitenmaterial auch ein Folienwerkstoff eingesetzt wurden, das Deckseitenmaterial 2 oder das Rückseitenmaterial 3 oder beide d. h. das Deckseitenmaterial 2 und auch das Rückseitenmaterial 3 des kristallinen photovoltaischen Solarmoduls 1 aus einem speziellen Bor-Silikat-Glas 7 mit einem Ausdehnungskoeffizienten von kleiner gleich 4,5x10⁻⁶ /K bis größer gleich 2x10⁻⁶ /K bei Raumtemperatur ausgebildet. Die Solarzellen 5 größerer Abmessungen sind, wie bisher bereits bekannt, in ein Einbettungsmaterial 4 eingelegt. Die eingebetteten Solarzellen 5 größerer Abmessungen sind mit ebenfalls im Einbettungsmaterial 4 eingebetteten Solarzellenverbindern 6 untereinander wie üblich verschalteten. Seitlich außen ist um das Deckseitenmaterial 2, die eingebetteten Solarzellen 5 größerer Abmessungen und um angeordneten Rückseitenmaterial 3 ein Modulrahmen mit nach außen geführten Anschlüssen angeordnet. Neben dem Kantenschutz gegen mechanische Beschädigungen erfolgt mittels dem Modulrahmen auch die Lagefixierung des plattenförmigen Solarmoduls. Das Bor-Silikat-Glas 7 kann je nach Einsatzfall wahlweise nur als Deckseitenmaterial 2 oder nur als Rückseitenmaterial 3 in Kombination mit einem geeigneten anderen Material oder auch beidseitig als Deck- und Rückseitenmaterial 2, 3 angeordnet sein. Die beidseitige Anordnung hat den Vorteil, dass die Ausdehnung der Seitenmaterialien mit der Ausdehnung der Solarzellen vor allem bei Solarzellen größerer Abmessungen mit einer Kantenlänge von größer - gleich 150 mm nahezu identisch verläuft.

Die Materialzusammensetzung des Bor-Silikat-Glases 7 ist so gewählt, dass das verwendete Bor-Silikat-Glas 7 für das Deck- und/oder Rückseitenmaterial 2, 3 einen linearen Ausdehnungskoeffizienten zwischen minimal 2 bis maximal 4,5x10⁻⁶/K gemessen bei Raumtemperatur besitzt. Damit ist sein Ausdehnungskoeffizient fast identisch mit dem von dem als Solarzellenmaterial verwendeten kristallinen Silizium. Die Siliziummaterialien für die Solarzellen besitzen bei Raumtemperaturen einen Ausdehnungskoeffizienten von ca. 2,6x10⁻⁶/K. Das bedeutet, die Solarzelle und das Bor-Silikat-Glas 7 dehnen sich nahezu gleichartig aus.

Da sich nun Solarzellenmaterial und Deckseiten- und /oder Rückseitenmaterial nahezu in ihrem Ausdehnungsverhalten identisch verhalten, werden die Verbindungsleitungen, d. h. die Solarzellenverbinder 6 kaum noch auf Dehnung und Stauchung beansprucht. Die Verformung der Leiterbahnen wird deshalb weitgehend reduziert. Die Materialversprödung des Leitermaterials verläuft viel langsamer als bisher. Dadurch steigt die Lebensdauer der neuartigen kristallinen photovoltaischen Solarmodule 1 erheblich.

Diese neuartige Ausbildung des kristallinen photovoltaischen Solarmoduls 1 mit dem Bor-Silikat-Glas 7 als Deck- und/oder Rückseitenmaterial 2, 3 wird bevorzugt bei Solarzellen 5 eingesetzt, die eine Kantenlänge von größer - gleich 150 mm besitzen.

Bevorzugt ist die Oberfläche des speziellen Bor-Silikat-Glases 7 mit einer Antireflex-Beschichtung in einer oder mehreren Schichten beschichtet ausgebildet. Dadurch wird der Anteil des reflektierten Anteils der einfallenden Lichtstrahlen verringert und die Energieausbeute wird verbessert. Zudem entfallende störende Spiegelungen für die Umgebung in der diese neuartigen Solarmodule installiert sind.

Die gleiche Wirkung, wie unmittelbar vorstehend beschrieben kann erreicht werden, wenn die Oberfläche des speziellen Bor-Silikat-Glases 7 mit reflexionsmindernden, regelmäßig geordneten oder unregelmäßigen Oberflächenstrukturen >50pm ausgebildet ist.

Bevorzugt ist das spezielle Bor-Silikat-Glas 7 als Gussglas ausgeführt. Dies bringt vor allem Kostenvorteile.

In einer bevorzugten Materialzusammensetzung sind einzelne Legierungsbestandteile in solchen Mengenanteilen vorhanden, dass die Eigenschaften des speziellen Bor-Silikat-Glases 7 so ausgebildet sind, dass seine solare Transmission >90 % beträgt. Dadurch lässt sich die Energieausbeute eines solchen kristallinen photovoltaischen Solarmoduls 1 weiter steigern.

Der neuartige Einsatz von Bor-Silikat-Glas als Deck- und/oder Rückseitenmaterial 2, 3 ist vor allem vorteilhaft bei großflächigen Solarzellen oder bei Solarzellen mit erhöhtem Wirkungsgrad.

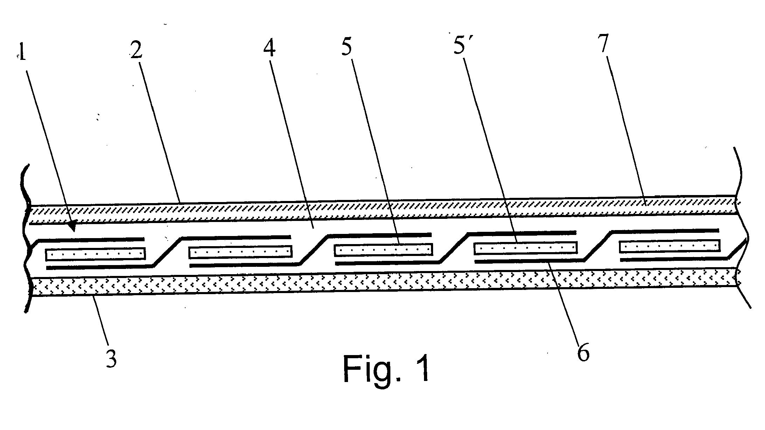

Die Erfindung soll nachstehend in einem Ausführungsbeispiel an Hand der Figur 1 näher erläutert werden.
- Fig.1: im Querschnitt den Aufbau eines erfindungsgemäßen kristallinen photovoltaischen Solarmoduls 1

Im Inneren des neuartigen kristallinen photovoltaischen Solarmoduls 1 sind mehrere Solarzellen 5 größerer Abmessungen definiert beabstandet in einem Einbettungsmaterial 4 eingebettet und nebeneinander angeordnet. Diese einzelnen Solarzellen 5 sind untereinander mit Verbindungsleitern 6, aus verzinnten Cu-Flachleiternmaterial in Reihenschaltung, verbunden, wobei jeweils der Ausgang einer Solarzelle 5 mit dem Eingang einer daneben angeordneten Solarzelle 5' verschaltet ist. Das Einbettungsmaterial 4 dient gleichzeitig als Klebeverbindungsschicht zwischen Deckseitenmaterial 2 und Rückseitenmaterial 3, so dass ein fester Verbund zwischen Deckseitenmaterial 2, Einbettungsmaterial 4 und Rückseitenmaterial 3 entseht. In Richtung der Lichtquelle ist über dem Einbettungsmaterial 4 als Deckseitenmaterial 2 in neuartiger Art und Weise eine Bor-Silikat-Glasscheibe 7 angeordnet. Die Materialzusammensetzung dieser Bor-Silikat-Glasscheibe 7 ist so eingestellt, dass diese einen linearen Ausdehnungskoeffizienten von 3,25 x 10⁻⁶ /K besitzt. Bei diesem Ausdehnungskoeffizienten besteht eine optimale Übereinstimmung der linearen Ausdehnung der Bor-Silikat-Glasscheibe 7 mit dem nichtlinearen Ausdehnungsverhalten der Solarzelle größerer Abmessung des Siliziums bezogen auf den gesamten möglichen Temperaturbereich am Einsatzort des photovoltaischen Solarmoduls 1. Das bedeutet, dass die beiden Kennlinien der Ausdehnungskoeffizienten im Mittel über den gesamten möglichen Temperaturbereich die geringsten Abstände haben. Auf der Rückseite ist das kristalline photovoltaische Solarmodul 1 mit einem Rückseitenmaterial 3, wie z. B. einer aufkaschierten Kunststofffolie flüssigkeitsdicht verschlossen. Anstelle der Kunststofffolie kann ebenso eine andere glasartige Trägerscheibe eingesetzt werden. Besonders vorteilhaft ist es, wenn auch das Rückseitenmaterial 3 aus einem Bor-Silikat-Glasmaterial ausgebildet ist.

Durch den neuartigen Aufbau des photovoltaischen Solarmoduls 1 mit dem Bor Silikat-Glas 7 wird gegenüber den bisher bekannten Ausbildungen, eine erhöhte mechanische Stabilität des photovoltaischen Solarmoduls 1 bei angepasstem Ausdehnungskoeffizienten erreicht. Auch die Transparenz des Deckseitenmaterials 2 kann durch die Verwendung von hochtransparentem Kalk-Natron-Glas erheblich verbessert werden (bei Anordnung von Bor-Silikat-Glas als Rückseitenmaterial), wodurch sich die Energiebilanz verbessert.

Außerdem wird der thermomechanische Stress auf die Verbindungsleiter 6 wesentlich reduziert, d. h. die ständig wechselnden Belastungen wie Stauchung, Dehnung und Biegebeanspruchungen der Verbindungsleiter 6 werden weitgehend vermieden, was letztlich zu einer besseren Resistenz gegenüber Umwelteinflüssen und damit zu einer erheblich längern Lebensdauer des gesamten Solarmoduls führt.

### Liste der Bezugszeichen

- 1: kristallines photovoltaisches Solarmodul
- 2: Deckseitenmaterial
- 3: Rückseitenmaterial
- 4: Einbettungsmaterial
- 5 und 5': Solarzellen
- 6: Verbindungsleiter
- 7: Bor-Silikat-Glas

## Patentansprüche

1. Kristallines photovoltaisches Solarmodul, insbesondere für photovoltaische Solarmodule in Plattenform mit einer dem einfallenden Licht zugewandten Deckseitenmaterial (2) aus Silikatglas, einem Einbettungsmaterial (4) mit darin eingebetteten untereinander durch Solarzellenverbinder (6) verschalteten Solarzellen (5) größerer Abmessungen, einem dahinter angeordneten Rückseitenmaterial (3) aus Silikatglas oder einem Folienwerkstoff, ohne oder mit einem außen darum angeordneten Modulrahmen mit nach außen geführten Anschlüssen,
**dadurch gekennzeichnet,**
**dass** das Deckseitenmaterial (2) und/oder das Rückseitenmaterial (3) des kristallinen photovoltaischen Solarmoduls (1) aus einem speziellen Bor-Silikat-Glas (7) mit einem Ausdehnungskoeffizienten von kleiner gleich 4,5 x10⁻⁶ /K bis größer gleich 2x10⁻⁶ /K bei Raumtemperatur besteht.

2. Kristallines photovoltaisches Solarmodul nach Anspruch 1,
**dadurch gekennzeichnet,**
**dass** die Solarzellen (5) eine Kantenlänge von größer - gleich 150 mm besitzen.

3. Kristallines photovoltaisches Solarmodul nach Anspruch 1,
**dadurch gekennzeichnet,**
**dass** die Oberfläche des speziellen Bor-Silikat-Glases (7) mit einer Antireflex-Beschichtung in einer oder mehreren Schichten beschichtet ist.

4. Kristallines photovoltaisches Solarmodul nach Anspruch 1,
**dadurch gekennzeichnet,**
**dass** die Oberfläche des speziellen Bor-Silikat-Glases (7) mit reflexionsmindernden, regelmäßig geordneten oder unregelmäßigen Oberflächenstrukturen >50pm ausgebildet ist.

5. Kristallines photovoltaisches Solarmodul nach Anspruch 1,
**dadurch gekennzeichnet,**
**dass** das spezielle Bor-Silikat-Glas (7) als Gussglas ausgeführt ist.

6. Kristallines photovoltaisches Solarmodul nach Anspruch 1,
**dadurch gekennzeichnet,**
**dass** das spezielle Bor-Silikat-Glas (7) so ausgebildet ist, dass seine solare Transmission >90 % beträgt.
